# EUROPEAN PATENT APPLICATION

(11) **EP 4 618 139 A1**
(43) Date of publication of application: **17.09.2025**
(21) Application number: 25163144.6
(22) Date of filing: 12.03.2025
(51) Int. Cl.: H01L 21/673

(54) **WAFER BOAT**

(30) Priority: 15.03.2024 US 202463565941 P
(71) Applicant: ASM IP Holding B.V., 1322 AP Almere (NL)
(72) Inventor: JADDI, Sahar, 1322 AP Almere (NL); OOSTERLAKEN, Theodorus G.M., 1322 AP Almere (NL); BOONSTRA, Klaas P., 1322 AP Almere (NL); VAN AERDE, Steven R. A., 1322 AP Almere (NL); MEHDI, Hussein, 1322 AP Almere (NL); CARVALHO DE ARAÚJO, Laryssa Mirelly, 1322 AP Almere (NL)
(74) Representative: V.O.

(57) **Abstract**

A wafer boat for holding substrates in a spaced vertical arrangement is disclosed. The boat comprises a first end plate and a second end plate spaced apart in a boat axis direction; first and second side rods and a back rod, the rods extending between the first end plate and the second end plate; the back rod comprising a plurality of back rod supports for at least partially supporting a wafer, the back rod supports being substantially semicircular in shape and spaced apart in the boat axis direction; the first and second side rods comprising a plurality of first and second side rod supports respectively, being spaced apart in the boat axis direction; wherein the first and second side rod supports each comprise a wafer contact portion being substantially arc shaped.

## Description

### FIELD OF INVENTION

The present application relates generally to substrate processing and, more particularly, to apparatus for supporting substrates.

### BACKGROUND OF THE DISCLOSURE

Batch production apparatus such as vertical furnaces allow many substrates to be processed simultaneously in the same reaction chamber, which can increase substrate processing throughput. In order to support large numbers of substrates in the reaction chamber, a wafer boat having a series of vertically spaced apart wafer supports is commonly used. Substrates can be loaded into and unloaded from the wafer boat in a wafer transfer chamber. The boat can be moved into the reaction chamber for wafer processing and removed after processing is completed.

A wafer held by a wafer support undergoes local stress at the points of contact with the wafer support, due to the weight of the wafer. When the local stress exceeds the yield strength of the wafer material, undesirable plastic deformation, or slip, of the wafer can occur. This effect can be more pronounced at high process temperatures as such temperatures can lead to decrease in the yield strength. Slip can cause multiple issues such as fracture of the wafer, defects, difficulties in depositing uniform overlayers.

So-called "long finger boats" provide wafer support by means of long, narrow, straight finger supports. The supports need to be thick enough to not bend significantly when a wafer is placed thereon. Sufficient space needs to be provided between vertically adjacent finger supports such that any bending which does take place does not result in a support making contact with a wafer held by an adjacent support below. This results in a reduced wafer capacity as the number of supports that can be provided is reduced.

Therefore, there is a need for wafer boats which apply minimal localized stresses to the wafers supported therein. There is also a need for wafer boats which allow a large number of wafers to be accommodated while applying minimal localized stresses to the wafers supported therein.

### SUMMARY OF THE DISCLOSURE

According to a first embodiment of the present invention, there is provided a wafer boat for holding substrates in a spaced vertical arrangement, the boat comprising a first end plate and a second end plate spaced apart in a boat axis direction; first and second side rods and a back rod, the rods extending between the first end plate and the second end plate; the back rod comprising a plurality of back rod supports for at least partially supporting a wafer, the back rod supports being substantially semicircular in shape and spaced apart in the boat axis direction; the first and second side rods comprising a plurality of first and second side rod supports respectively, being spaced apart in the boat axis direction; wherein the first and second side rod supports each comprise a wafer contact portion being substantially arc shaped.

It is an advantage of embodiments of the present invention that a boat can be provided which minimizes local stress on a wafer supported therein. It is an advantage of embodiments of the present invention that a boat can be provided which minimizes local stress while also accommodating a large number of slots for supporting wafers, for example more than 150 slots. It is an advantage of embodiments of the present invention that a boat can be provided which minimizes local stress while also allowing a small degree of misalignment between side and back rod supports, such that tolerances on manufacturing such a boat may be less strict than for example a long finger boat.

The first and second side rods may be disposed approximately diametrically with respect to a central axis of the boat, while being slightly offset to a front side of the wafer boat, from which side a wafer can be inserted into the boat, and wherein the back rod is disposed substantially equidistantly from the first and second side rods.

Each substantially arc shaped wafer contact portion may subtend an angle at a central axis of the boat which is between 10 degrees and 30 degrees. The subtended angle may be between 15 degrees and 25 degrees.

The first and second side rods may each comprise a first side facing towards a central boat axis and a second side facing away from the central boat axis, wherein the second side comprises two substantially planar surfaces each extending between the first end plate and the second end plate, wherein no slots are formed in at least one of the first and second substantially planar surfaces. An angle between the two substantially planar surfaces may be between 15 and 30 degrees.

It is an advantage of embodiments of the present invention that, by providing the side rod with two planar surfaces, a manufacturing process of the boat may be made easier.

For each side rod the second planar surface may be closer to the back rod than the first planar surface is and no slots may be formed in the second planar surfaces. For each side rod the second planar surface may be closer to the back rod than the first planar surface is and slots may be formed in the second planar surfaces. The first planar surface may have a width in a wafer insertion plane which is at least twice a width of the second planar surface in the wafer insertion plane.

The first and second side rods may extend between first and second ends in a wafer insertion plane, the second ends being disposed closer to the back boat rod than the first ends are, and a width of a side rod at the first end may be different to a width of the side rod support at the second end.

The first and second side rods extend between first and second ends in a wafer insertion plane, the second ends being disposed closer to the back boat rod than the first ends are , and a width of a side rod at the first end may be substantially equal to a width of the side rod at the second end.

The boat may comprise at least 160 back rod supports and at least 160 corresponding sets of first and second side rod supports, thus providing space for supporting at least 160 wafers in the boat. This can allow more substrates to be processed at the same time.

The first end plate and the second end plate may each comprise a cut-out portion centred on a central boat axis.

According to a second aspect of the present invention there is provided a furnace apparatus for processing substrates, comprising a reaction chamber arranged for receiving one or more substrates supported on a wafer boat; one or more heating elements for heating the reaction chamber; a gas flow source for providing a flow of gas into the reaction chamber; a gas exhaust for removing gas from the reaction chamber; and a wafer boat according to the first embodiment. The wafer boat may support at least 150 substrates, at least 160 substrates, or at least 165 substrates.

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

### BRIEF DESCRIPTION OF THE DRAWING FIGURES

Certain embodiments of the present invention will now be described, by way of example, with reference to the accompanying drawings, in which:
Figure 1a is a schematic perspective view of a wafer boat according to embodiments of the present invention;
Figure 1b is a schematic perspective view of a wafer boat according to embodiments of the present invention, along with a wafer which may be inserted into the wafer boat;
Figure 2a is a cross-sectional view in a wafer insertion plane of a first back boat rod which may be comprised in a wafer boat according to embodiments of the present invention;
Figure 2b is a cross-sectional view in a wafer insertion plane of a second back boat rod which may be comprised in a wafer boat according to embodiments of the present invention;
Figures 3a and 3b are cross-sectional views in a wafer insertion plane of a side rod which may be comprised in a wafer boat according to embodiments of the present invention;
Figure 3c is a cross-sectional view in a wafer insertion plane of a wafer boat according to embodiments of the present invention;

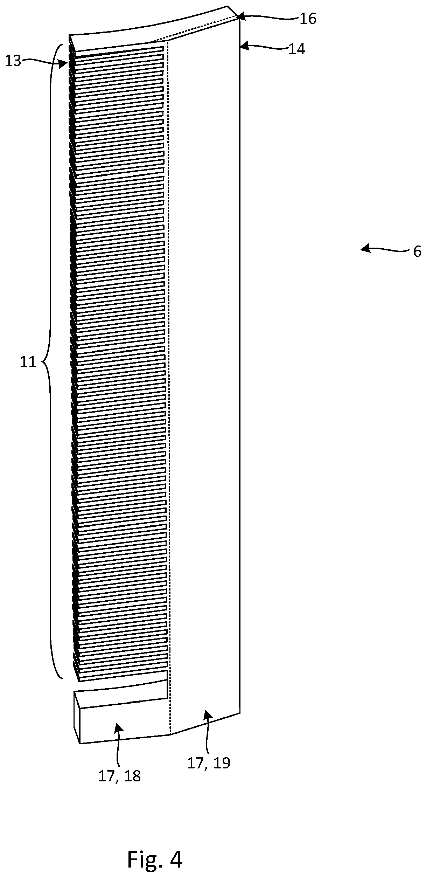

Figure 4 is a schematic perspective view of a first side rod which may be comprised in a wafer boat according to embodiments of the present invention;
Figure 5a is a top down view of wafer supports in a long finger boat;
Figure 5b is a top down view of wafer supports in a standard boat;
Figure 6a shows simulated stress on a wafer supported on supports as shown in Figure 5a;
Figure 6b shows simulated stress on a wafer supported on supports as shown in Figure 5b;
Figure 6c shows simulated stress on a wafer supported on supports as shown in Figure 3c;
Figure 7 is a schematic cross sectional view along a central axis of a vertical furnace apparatus comprising a boat according to embodiments of the present invention.

It will be appreciated that elements in the figures are illustrated for simplicity and clarity and have not necessarily been drawn to scale. For example, the dimensions of some of the elements in the figures may be exaggerated relative to other elements to help improve understanding of illustrated embodiments of the present disclosure.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

As used herein, the term "substrate" may refer to any underlying material or materials, including any underlying material or materials that may be modified, or upon which, a device, a circuit, or a film may be formed. The "substrate" may be continuous or non-continuous; rigid or flexible; solid or porous; and combinations thereof. The substrate may be in any form, such as a powder, a plate, or a workpiece. Substrates in the form of a plate may include wafers in various shapes and sizes. Substrates may be made from semiconductor materials, including, for example, silicon, silicon germanium, silicon oxide, gallium arsenide, gallium nitride and silicon carbide.

A continuous substrate may extend beyond the bounds of a process chamber where a deposition process occurs. In some processes, the continuous substrate may move through the process chamber such that the process continues until the end of the substrate is reached. A continuous substrate may be supplied from a continuous substrate feeding system to allow for manufacture and output of the continuous substrate in any appropriate form.

The illustrations presented herein are not meant to be actual views of any particular material, structure, or device, but are merely idealized representations that are used to describe embodiments of the disclosure.

The particular implementations shown and described are illustrative of the invention and its best mode and are not intended to otherwise limit the scope of the aspects and implementations in any way. Indeed, for the sake of brevity, conventional manufacturing, connection, preparation, and other functional aspects of the system may not be described in detail. Furthermore, the connecting lines shown in the various figures are intended to represent exemplary functional relationships and/or physical couplings between the various elements. Many alternative or additional functional relationship or physical connections may be present in the practical system, and/or may be absent in some embodiments.

It is to be understood that the configurations and/or approaches described herein are exemplary in nature, and that these specific embodiments or examples are not to be considered in a limiting sense, because numerous variations are possible. The specific routines or methods described herein may represent one or more of any number of processing strategies. Thus, the various acts illustrated may be performed in the sequence illustrated, in other sequences, or omitted in some cases.

The subject matter of the present disclosure includes all novel and nonobvious combinations and subcombinations of the various processes, systems, and configurations, and other features, functions, acts, and/or properties disclosed herein, as well as any and all equivalents thereof.

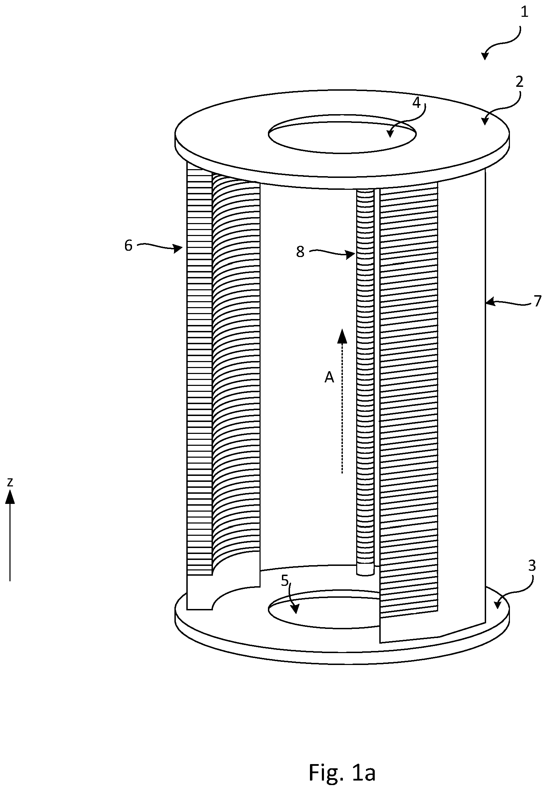

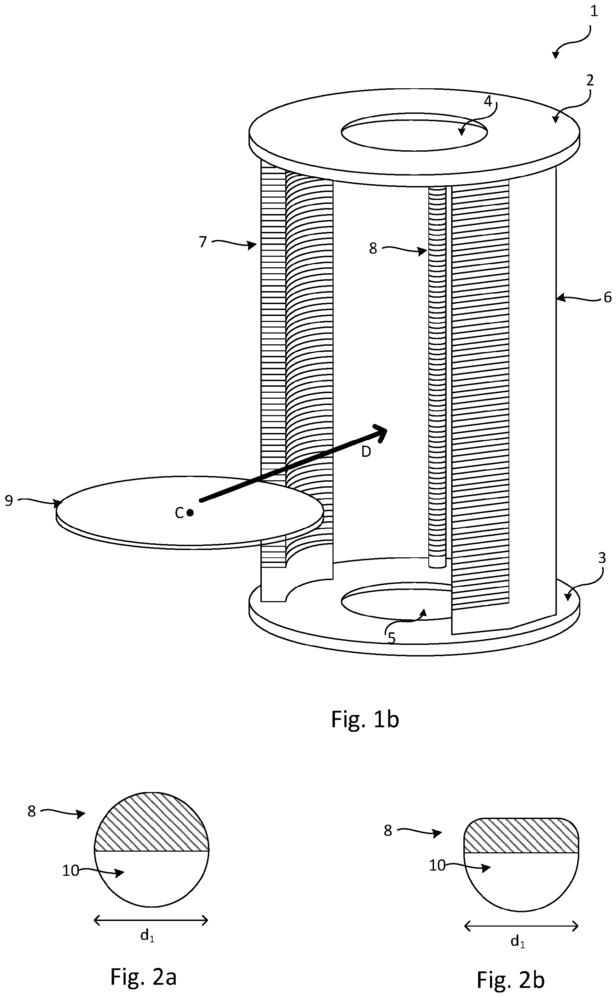

Referring to Figures 1a and 1b, a wafer boat 1 according to embodiments of the present invention comprises a first end plate 2 and a second end plate 3. The first end plate 2 and the second end plate 3 are spaced apart in a boat axis direction z. The first end plate 2 and the second end plate 3 may be generally circular in shape and aligned with their centres along the same axis in the boat axis direction, herein referred to as the central boat axis A. The first and second end plates 2, 3 may have respective cut-out central circular sections 4**,** 5 which can help to reduce thermal stress in the end plates 2, 3. In some embodiments, the first end plate 2 and the second end plate 3 may have shapes which are not circular and the central boat axis may be defined as a line which connects the centres of the first and second end plates 2, 3 along the boat axis direction. Support legs (not shown) may extend from a lower side of the second end plate 3.

The wafer boat 1 comprises a first side rod 6, a second side rod 7, and a back rod 8. The side rods 6, 7 and the back rod 8 each extend between the first end plate 2 and the second end plate 3. The rods 6, 7, 8 may be removably attached to the first and second end plates 2, 3, for example attached using screws (not shown). This can allow for the rods 6, 7, 8 to be individually removed and replaced in case of damage, without requiring the boat 1 as a whole to be replaced. The rods 6, 7, 8 may be attached to the first and second end plates 2, 3 by welded joints. This can allow for a more uniform thermal behaviour of the boat 1.

The rods 6, 7, 8 may be circumferentially distributed so as to define an opening through which a wafer 9 may be introduced into the boat 1 in a wafer introduction direction D, for example by a wafer transfer robot (not shown). For example, the first and second side rods 6, 7 may be disposed at positions which are slightly offset away from the back rod 8 from substantially diametrically opposed positions, and the back rod 8 may be located substantially equidistant from the first side rod 6 and the second side rod 7. The back rod 8 may be positioned such that the back rod 8 and the centre C of a wafer introduced into the boat 1 are collinear in the wafer introduction direction D. The wafer 9 may be, for example, a silicon wafer.

The back rod 8 comprises a plurality of back rod supports 10 for at least partially supporting a wafer 9 in the boat 1. The back rod supports 10 are spaced apart in the boat axis direction. The back rod supports 10 may be equally spaced apart in the boat axis direction as shown in Figure 1. In some embodiments the back rod supports 10 may be unequally spaced apart in the boat axis direction. The back rod supports 10 are substantially semicircular in shape with the diameter being provided by the back rod 8. The back rod supports 10 project towards the central boat axis A.

Referring also to Figure 2a, the back rod 8 may be generally cylindrical in shape with a series of slots cut into one side of the cylinder in planes perpendicular to the axis of the cylinder so as to form the semicircular back rod supports 10. The back rod 8 may have a non-cylindrical shape onto which the plurality of back rod supports 10 are mounted. Referring to Figure 2b, the back rod 8 may have a shape which comprises a half-cylinder into which a series of slots are cut in a plane perpendicular to the axis of the half-cylinder so as to form the semicircular back rod supports 10. The diameter d₁ of the semicircular back rod supports 10 may be between 5mm and 50mm, between 10mm and 45mm, between 15mm and 40mm, or between 20mm and 35mm. The diameter of the semicircular back rod supports 10 may be between 20mm and 25mm, between 25mm and 30mm, or between 30mm and 35mm.

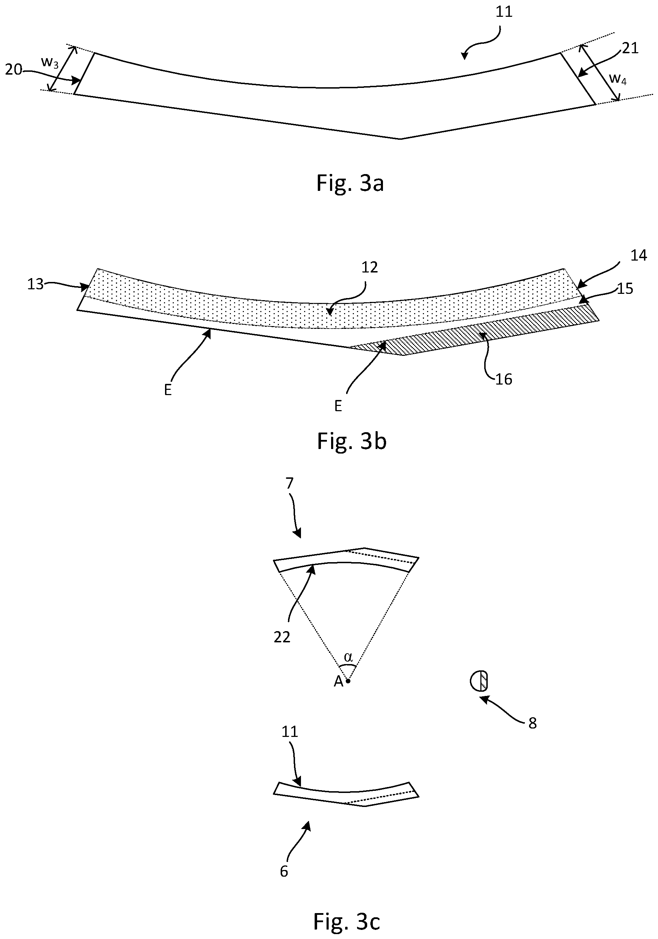

The first side rod 6 and the second side rod 7 have the same shape and so it will be understood that the following description of the first side rod 6 applies equally to the second side rod 7. Referring to Figures 3a and 3b, the first side rod 6 comprises a plurality of first side rod supports 11. Each first side rod support 11 comprises a wafer contact portion 12 which is substantially arc shaped. The wafer contact portion 12 is the portion of the first side rod support 11 which contacts a wafer 9 when the wafer 9 is supported in the boat 1. By providing an arc shaped contact portion 12, the wafer 9 can be supported over a greater length of its circumference as compared with, for example, a long finger boat, which can help to reduce stress on the wafer material, and correspondingly may help to reduce slip, especially at high temperatures. Furthermore, distributing the points of contact with the wafer over the arc shaped contact portion 12 may result in less bending of the support 11 compared with, for example, a long finger boat, which means that the thickness of the support 11 in the z direction need not be as large as in a long finger boat, allowing a relatively large number of wafers to be supported in the boat 1. For example, in a boat 1 according to embodiments of the present invention, a wafer may be supported by a set of a first side rod support, a second side rod support, and a back rod support, which are substantially coplanar. The boat 1 may comprise at least 150 such sets of supports, at least 160 sets of supports, or at least 165 sets of supports.

The contact portion 12 extends between a first end 13 and a second end 14. The first end 13 and the second end 14 subtend an angle α at the central axis A of the boat 1. The angle α may be between 10 and 40 degrees, between 10 and 30 degrees, between 15 and 35 degrees, between 20 and 30 degrees, between 15 and 25 degrees. The angle α may be between 20 and 25 degrees, or between 25 and 30 degrees. The first side rod support 11 may comprise an intermediate portion 15 extending in a direction radially away from the central boat axis A, which may be arc shaped or not. The intermediate portion 15 may be terminated at least partially by one or more straight edges E which are each spaced apart from the contact portion 12 in a substantially radial direction.

The first side rod 6 may comprise a first side rod body 16 to which the first side rod supports 11 are attached or with which the first side rod supports 11 form a continuous part, the first side rod supports 11 being spaced apart in a longitudinal direction along the first side rod body 16. The intermediate portion 15 of the first side rod support 11 may be attached or adjacent at one or more edges E to the first side rod body 16. The first side rod body 16 extends in the boat axis direction between the first end plate 2 and the second end plate 3.

In the present disclosure, where one element is described as being attached to another element, it will be understood that this may include an arrangement in which the two elements are manufactured or machined as separate parts and subsequently fixed together. Where one element is described as being attached to another element, it will be understood that this may include an arrangement in which a part is machined such that the first and second elements are part of one body without needing to physically bring together and fix one element to another. For example, a first side rod 6 may be formed by first machining a solid part having a constant cross section having the shape shown in Figure 3a and extending along an axis, and subsequently by forming a series of slots in the solid part, in a plane having the axis of the solid part as its normal. The remaining material of the solid part forms the supports 11 and side rod body 16.

The first side rod 6 may comprise a first side facing towards the central boat axis A and a second side 17 facing away from the central boat axis. The second side 17 may comprise first and second substantially planar surfaces 18, 19 respectively. The first and second substantially planar surfaces 18, 19 extend between the first end plate 2 and the second end plate 3. The second surface 19 is closer to the back rod 8 than the first planar surface. Slots may be formed in one, both, or neither of the first and second surfaces 18, 19. For example, in some embodiments, slots may be formed in the first planar surface 18 so as to at least partially provide the supports 11. The angle β between the planar surfaces 18, 19 as measured on the second side 17 may be between 185 and 220 degrees. The angle β may be between 195 and 210 degrees. The angle β may be between 200 and 205 degrees. Forming the second side 17 of two planar surfaces 18, 19 can help to provide a side rod 6 which is easy to manufacture.

The first and second planar surfaces 18, 19 have respective widths w₁, w₂ in a wafer insertion plane. The wafer insertion plane is a plane which has as its normal the boat axis direction z. The width w₁ of the first planar surface 18 may be at least twice the width w₂ of the second planar surface 19. The width w₁ of the first planar surface 18 may be at least 1.5 times the width w₂ of the second planar surface 19. The width w₁ of the first planar surface 18 may be at least 2.5 or at least 3 times the width w₂ of the second planar surface 19. The width w₁ of the first planar surface 18 may be between 1 times and 5 times the width w₂ of the second planar surface 19.

Referring again to Figure 3a, the side rod 6 extends between first and second ends 20, 21 in a wafer insertion plane, the second end 21 being disposed closer to the back boat rod 8 than the first end 20 is. The side rod 6 has a width w₃ at the first end 20 and a width w₄ at the second end 21 as measured in a wafer insertion plane and in a substantially radial direction. The width w₃ at the first end 20 may be different to the width w₄ at the second end 21. The width w₃ at the first end 20 may be substantially equal to the width w₄ at the second end 21.

By providing back rod supports 10 having a semicircular form in combination with first and second side rod supports 11, 22 having arc shaped wafer contact portions 12, a boat 1 can be provided which has a greater tolerance for alignment of corresponding supports in the boat axis direction while still providing the required wafer support. This can provide for easier manufacturing and transport of the boat 1.

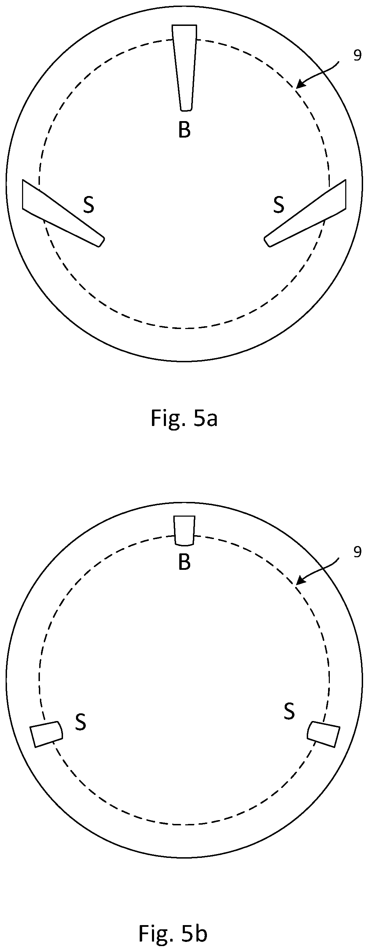

Finite element simulations were carried out to assess the stress on a wafer supported in a boat according to embodiments of the present invention, and to assess the stress on a wafer supported in a long finger boat and a standard boat as comparative examples. In the simulations, the wafer had a diameter of 300mm; the wafer and the boats had material properties identical to those of silicon. The simulated long finger boat wafer supports are shown in Figure 5a. The simulated standard boat wafer supports are shown in Figure 5b. In both figures, back rod supports are denoted B and side rod supports are labelled S. For the boat 1 according to embodiments of the present invention, the wafer supports shown in Figure 3c were used for the simulation.

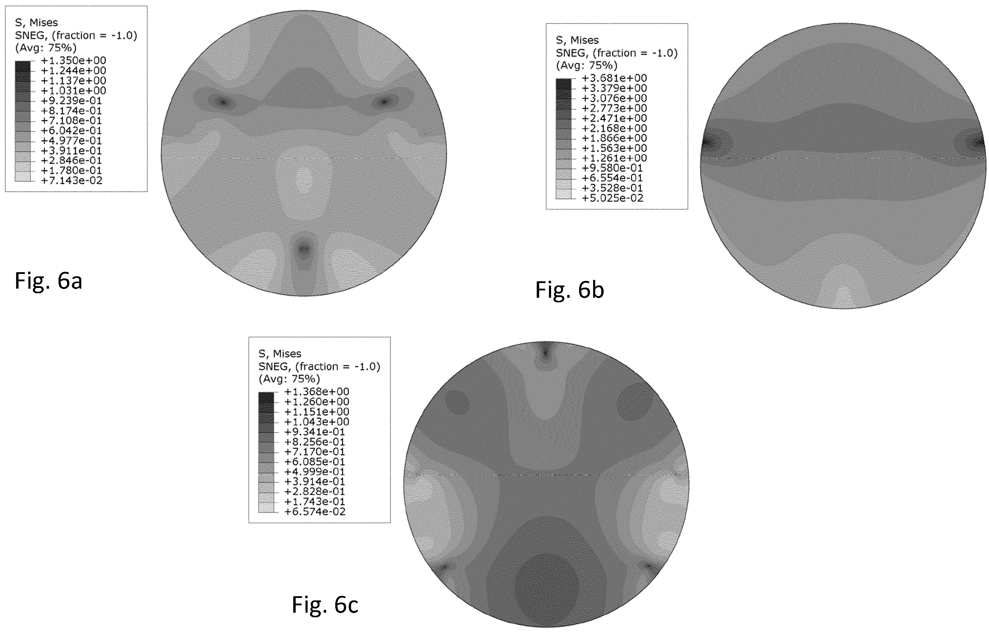

Referring to Figure 6a, the yield stress map for the wafer is shown for the long finger supports. Referring to Figure 6b, the yield stress map for the wafer is shown for the standard boat supports. Referring to Figure 6c, the yield stress map for the wafer is shown for a boat according to embodiments of the present invention as shown in Figure 3c. The highest stress value for the boat according to embodiments of the present invention was found to be comparable to that of the long finger boat and 67% less than that of the standard boat. The boat according to embodiments of the present invention allows for a comparable yield stress on the wafers compared to the long finger boat while accommodating many more wafers than the long finger boat.

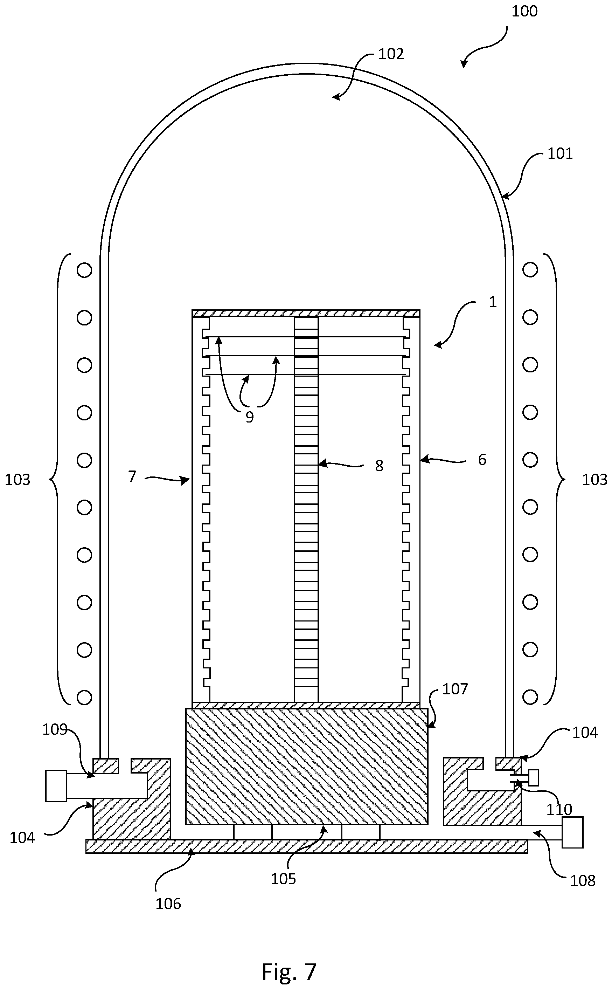

Referring to Figure 7, embodiments of the present invention may provide a vertical furnace apparatus 100 comprising a wafer boat 1 as described hereinbefore. The vertical furnace apparatus 100 comprises a reaction tube 101, which is generally bell jar shaped, defining a reaction space 102 therewithin. The reaction tube 101 is surrounded by heating means, such as one or more thermally resistive heating coils 103 powered by an electrical power supply (not shown). The heating means 103 is configured to provide heat to the reaction tube 101 which subsequently causes the reaction space 102 to be heated. The heating means 103 may be configured to heat the reaction space 102 to a temperature of 500C or higher, for example 800C, 900C, or 1000C. The reaction tube 101 may be supported at its lower end on a flange 104 for partially closing an open end of the reaction tube 101. The wafer boat 1 may enter and exit the reaction space 102 via a central furnace opening 105 provided in the flange 104. A vertically movably arranged door 106 may be configured to close off the opening 105 and may be configured to support the wafer boat 1. The wafer boat 1 may sometimes be inserted into the chamber while empty i.e. not supporting any wafers 9. The wafers 9 may be in some cases be dummy wafers which are not intended to be used for further manufacture. The door 106 may be provided with a pedestal 107. The pedestal 107 may be rotated to have the wafer boat 1 in the reaction space 102 rotating. The flange 104 may comprise a gas inlet 108 for providing a gas to the reaction space 102, and a gas exhaust duct 109 for removing gas from the reaction space 102. The gas may comprise, for example, argon, hydrogen, nitrogen oxygen, water vapor, oxygen with a trace amount of HCl, and/or any mixture of the preceding.

The apparatus 100 may be provided with a purge gas inlet 110 mounted on the flange 104 for providing a purge gas to the reaction space 102. In some embodiments, the purge gas inlet 110 is not provided and the gas inlet 108 is configured to provide both a process gas flow source for flowing a process gas into the reaction tube 101 and a purge gas flow source for flowing a purge gas into the reaction tube 101. For example, the gas inlet 108 may be coupled to a valve (not shown) coupled to a source of process gas and a source of purge gas, where the valve is configured to adapt at least a configuration in which only the process gas is allowed to flow through the gas inlet 108 and a configuration in which only the purge gas is allowed to flow through the gas inlet 108.

The boat 1 may be made of silicon. The boat may be made of silicon carbide. The boat may be made of quartz.

Although illustrative embodiments of the present invention have been described above, in part with reference to the accompanying drawings, it is to be understood that the invention is not limited to these embodiments. Variations to the disclosed embodiments can be understood and effected by those skilled in the art in practicing the claimed invention, from a study of the drawings, the disclosure, and the appended claims.

Reference throughout this specification to "one embodiment" or "an embodiment" means that a particular feature, structure or characteristic described in connection with the embodiment is included in at least one embodiment of the present invention. Thus, the appearances of the phrases "in one embodiment" or "in an embodiment" in various places throughout this specification are not necessarily all referring to the same embodiment. Furthermore, it is noted that particular features, structures, or characteristics of one or more embodiments may be combined in any suitable manner to form new, not explicitly described embodiments. The subject matter of the present disclosure includes all novel and nonobvious combinations and subcombinations of the various processes, systems, and configurations, and other features, functions, acts, and/or properties disclosed herein, as well as any and all equivalents thereof.

## Claims

1. A wafer boat for holding substrates in a spaced vertical arrangement, the boat comprising:
a first end plate and a second end plate spaced apart in a boat axis direction;
first and second side rods and a back rod, the rods extending between the first end plate and the second end plate;
the back rod comprising a plurality of back rod supports for at least partially supporting a wafer, the back rod supports being substantially semicircular in shape and spaced apart in the boat axis direction;
the first and second side rods comprising a plurality of first and second side rod supports respectively, being spaced apart in the boat axis direction;
wherein the first and second side rod supports each comprise a wafer contact portion being substantially arc shaped.

2. A wafer boat according to claim 1, wherein the first and second side rods are disposed approximately diametrically with respect to a central axis of the boat, while being slightly offset to a front side of the wafer boat, from which side a wafer can be inserted into the boat, and wherein the back rod is disposed substantially equidistantly from the first and second side rods.

3. A wafer boat according to claim 1 or 2, wherein each substantially arc shaped wafer contact portion subtends an angle at a central axis of the boat which is between 10 degrees and 30 degrees.

4. A wafer boat according to claim 1 or 2, wherein each substantially arc shaped wafer contact portion subtends an angle at a central axis of the boat which is between 15 degrees and 25 degrees.

5. A wafer boat according to any preceding claim, wherein the first and second side rods each comprise a first side facing towards a central boat axis and a second side facing away from the central boat axis, wherein the second side comprises two substantially planar surfaces each extending between the first end plate and the second end plate, wherein no slots are formed in at least one of the first and second substantially planar surfaces.

6. A wafer boat according to claim 5, wherein an angle between the two substantially planar surfaces is between 15 and 30 degrees.

7. A wafer boat according to any of claims 5 to 6, wherein for each side rod the second planar surface is closer to the back rod than the first planar surface and wherein no slots are formed in the second planar surfaces.

8. A wafer boat according to any of claims 5 to 6, wherein for each side rod the second planar surface is closer to the back rod than the first planar surface and wherein slots are formed in the second planar surfaces.

9. A wafer boat according to any of claims 4 to 8, wherein the first planar surface has a width in a wafer insertion plane which is at least twice a width of the second planar surface in the wafer insertion plane.

10. A wafer boat according to any preceding claim, wherein the first and second side rods extend between first and second ends in a wafer insertion plane, the second ends being disposed closer to the back boat rod than the first ends are, wherein a width of a side rod at the first end is different to a width of the side rod support at the second end.

11. A wafer boat according to any of claims 1 to 9, wherein the first and second side rods extend between first and second ends in a wafer insertion plane, the second ends being disposed closer to the back boat rod than the first ends are, wherein a width of a side rod at the first end is substantially equal to a width of the side rod at the second end.

12. A wafer boat according to any preceding claim, comprising at least 160 back rod supports and at least 160 corresponding sets of first and second side rod supports.

13. A wafer boat according to any preceding claim, wherein the first end plate and the second end plate each comprise a cut-out portion centred on a central boat axis.

14. A furnace apparatus for processing substrates, comprising:
a reaction chamber arranged for receiving one or more substrates supported on a wafer boat;
one or more heating elements for heating the reaction chamber;
a gas flow source for providing a flow of gas into the reaction chamber;
a gas exhaust for removing gas from the reaction chamber; and
a wafer boat according to any preceding claim.
